# EUROPEAN PATENT APPLICATION

(11) **EP 3 447 754 A1**
(43) Date of publication of application: **27.02.2019**
(21) Application number: 17895500.1
(22) Date of filing: 31.08.2017
(51) Int. Cl.: G09F 9/302, G09F 9/33, F16M 11/12, F16M 11/18, F21S 8/00, F21V 21/30

(54) **OSCILLATING DISPLAY DEVICE**

(30) Priority: 11.07.2017 CN 201710560926
(71) Applicant: Huasun Technology Co., Ltd., Foshan, Guangdong 528226 (CN)
(72) Inventor: QIN, Feizhou, FOSHAN, Guangdong 528226 (CN); LIANG, Heqiu, FOSHAN, Guangdong 528226 (CN)
(74) Representative: Jarrett, Daniel Phillip
(86) International application number: PCT/CN2017/099982
(87) International publication number: WO 2019/010770

(57) **Abstract**

A moving head display device is disclosed, including a support stand and a display screen module disposed on the support stand. A side of the support stand facing the display screen module is provided with a first connector, a back surface of the display screen module is provided with a second connector, and the the second connector is detachably connected to and engaged with the first connector. For the moving head display device according to embodiments of the present disclosure, the display screen module is mounted on the support stand in a snap fit manner, so that it is convenience to install the display screen module. The display screen module can be supported on the ground or mounted on other holders by the support stand, to facilitate installation and positioning of the display screen module. Moreover, the display screen module is easy to be detached from the support stand, and it is convenient to splice a plurality of display screen modules into a large-area display screen to realize a function of large screen display. When the function of large screen display is not required, the spliced display screen modules can be split to be installed into their respective support stands to serve as stage lamps. This invention is extremely flexible and reliable in use.

## Description

### TECHNICAL FIELD

The present disclosure relates to the field of display technologies, and in particular, to a moving head display device.

### BACKGROUND

With the continuous advancement of society and the development of technology, the manufacturing technology of display screens (which usually refer to LED display screens, or OLED display screens) is also maturing. The display screens are used more widely, in more and more occasions and methods, such as stage, exhibition and other occasions. In order to accommodate different needs, people sometimes splice a number of display screens into one large display screen, and sometimes requires the display screen to move, to increase the visual effect.

At present, the LED (also OLED) display screen is mostly a large-area display screen which is spliced by a plurality of LED display screens, which is fixedly installed in one place and plays some video text. When the content is not played, it is a big "blackboard", which is rather dull. On the other hand, a few of the moving head stage lights in the prior art are also equipped with an LED display screen for displaying video text and the like. However, the support arm is fixedly connected with the outer frame of two sides of the LED display screen of the lamp head, and the LED display screen is difficult to be taken down separately as an ordinary LED display screen, and cannot be spliced into a large-area LED display screen.

### SUMMARY

Based on this, in order to overcome the deficiencies of the prior art, the present disclosure provides a moving head display device that can disassemble the display screen module thereon, thereby facilitating the assembly of a plurality of display screen modules into a large-area display screen.

A technical solution is described as below.

A moving head display device includes a support stand and a display screen module disposed on the support stand, a side of the support stand facing the display screen module is provided with a first connector, a back surface of the display screen module is provided with a second connector, and the second connector is detachably connected to and engaged with the first connector.

For the moving head display device according to embodiments of the present disclosure, the display screen module is mounted on the support stand in a snap fit manner, so that it is convenience to install the display screen module. The display screen module can be supported on the ground or mounted on other holders by the support stand, to facilitate installation and positioning of the display screen module. Moreover, the display screen module is easy to be detached from the support stand, and it is convenient to splice a plurality of display screen modules into a large-area display screen to realize a function of large screen display. When the function of large screen display is not required, the spliced display screen modules can be split to be installed into their respective support stands to serve as stage lamps. The moving head display device according to the present disclosure is extremely flexible in use, and reasonably structured so that it is simple in structure and easy to manufacture.

The above technical solution is further described as below:
In one embodiment, the moving head display device further includes a spot lamp disposed on the display screen module. The spot lamp is detachably connected to the display screen module. In this embodiment, the spot lamp and the display screen module are combined to form a display and lighting portion, so that the moving head display device can be used both for displaying a played video, dynamic images, or the like, and for lighting, decoration, or other functions of a lamp. The spot lamp is detachably connected to the display screen module, so that if it is not necessary to use both the display and lighting capacities of the moving head display device, the spot lamp can be removed from the moving head display device, and the spot lamp and the display screen module can be used separately, further increasing the operational flexibility of the moving head display device, and integrating multiple functions into one machine. Moreover, the removal of the spot lamp also facilitates to splice the display screen modules into a large-area display screen.

In one embodiment, the spot lamp is disposed on an outer perimeter of the display screen module, and a light emitting surface of the spot lamp and a light emitting surface of the display screen module are located on a same side, so that the audience can watch both images displayed on the display screen module and light beam from the spot lamp.

In one embodiment, the display screen module comprises a support frame and a display unit disposed on the support frame, the support frame is provided with a splicing part adapted to be connected to an adjacent display screen module during splicing, and the splicing part is provided with a splicing and locking structure. The splicing and locking structure can both splice a plurality of display screen modules together, and separate the spliced plurality of display screen modules from each other.

In one embodiment, a lower side of the support frame is provided with a positioning pin, and an upper side of the support frame is provided with a positioning hole cooperated with a positioning pin on an adjacent display screen module. The arrangement of the positioning pin facilitates the positioning of the display screen modules when the display screen modules are spliced together. Moreover, the positioning pin is disposed on the lower side of the support frame, so that the display screen module can stand on the ground or other mounting surfaces to display, to avoid direct contact between the display unit and the mounting surface, and avoid damage caused by bumping, scratching or the like.

In one embodiment, a side of the support frame facing the display unit is provided with a first magnetic member, and the display unit is provided with a second magnetic member adapted to be magnetically connected to the first magnetic member. The arrangement of the first magnetic member and the second magnetic member can make the assembly of the display unit and the support frame convenient.

In one embodiment, the support frame includes a base, a support arm disposed on the base, and a holding plate disposed on the support arm, the holding plate is rotatably connected to the support arm through a first rotating component such that the holding plate is rotatable relative to the support arm in a first direction, the support arm is rotatably connected to the base such that the support arm is rotatable relative to the base in a second direction, and the holding plate is provided with the first connector. When the holding plate is driven by a driving force to rotate, the display screen module and the spot lamp can also be driven to rotate in the first direction, for example, in a vertical direction, so that the display and lighting portion can swing in the vertical plane, thereby adjusting the angle of the display and lighting portion in the vertical direction. When the support arm is driven by the driving force to rotate, the holding plate and the display and lighting portion can also be driven to rotate in the second direction, for example, in a horizontal direction, thereby adjusting the angle of the display and lighting portion in the second direction. The combination of rotation in the first direction and the second direction realizes three-dimensional rotation of the display and lighting portion.

In one embodiment, the moving head display device further includes a first drive mechanism connected to the first rotating component and configured to drive the support plate to rotate relative to the support arm, and a second drive mechanism connected to the second rotating component and configured to drive the support arm to rotate relative to the base. The arrangement of the first drive mechanism and the second drive mechanism can realize automatic three-dimensional rotation of the display and lighting portion.

In one embodiment, the support arm is provided with a receiving groove and two fixed arms located on both sides of the receiving groove, and the holding plate is disposed in the receiving groove, and the holding plate is connected to the two fixed arms by two first rotating components respectively. The receiving groove is provided for mounting the holding plate, and the fixed arms on both sides provide stable fixation for the holding plate, so the holding plate can rotate smoothly and reliably.

In one embodiment, the moving head display device further includes a first electric wire, the base is provided with a built-in first power source and a built-in control circuit board, the first rotating component is provided with a first through hole, the second rotating component is provided with a second through hole, one end of the first electric wire is disposed within the base and configured to be electrically connected to the first power source and/or the control circuit board, and another end of the first electric wire is electrically connected to the display screen module through the second through hole, an inner side of the support arm, and the first through hole successively. The first power source is configured to supply power to the display screen module, the spot lamp, the first drive mechanism, and the second drive mechanism, and the control circuit board is configured to transmit control signals to the display screen module, the spot lamp, the first drive mechanism, and the second drive mechanism, to control their operation. The first electric wire implements electrical connections between the power source and the powered unit and between the control circuit board and the controlled unit. Further, the first electric wire in the present disclosure is led out from the first rotating shaft, the inner side of the support arm, and the second rotating shaft, so that the first electric wire is received in a concealed form. In addition, the first through hole and the second through hole may have enough space to ensure that the first electric wire does not fall off the two holes due to the rotation of structures.

### BRIEF DESCRIPTION OF THE DRAWINGS

FIG. 1 is a schematic structural diagram illustrating a moving head display device according to a first embodiment of the present disclosure.
FIG. 2 is an exploded diagram illustrating the moving head display device according to the first embodiment of the present disclosure.
FIG. 3 is a schematic structural diagram illustrating a spot lamp according to the first embodiment of the present disclosure.
FIG. 4 is a schematic diagram illustrating an assembly of the spot lamp and a display screen module according to the first embodiment of the present disclosure.
FIG. 5 is an exploded diagram illustrating a display screen module according to the first embodiment of the present disclosure.
FIG. 6 is a schematic structural diagram illustrating a display unit according to the first embodiment of the present disclosure.
FIG. 7 is a schematic diagram illustrating a front side of a large-area display screen according to the first embodiment of the present disclosure.
FIG. 8 is a schematic diagram illustrating a rear side of a large-area display screen according to the first embodiment of the present disclosure.
FIG. 9 is a schematic diagram illustrating a rear side of the moving head display device according to the first embodiment of the present disclosure.
FIG. 10 is a partial cross-sectional diagram of a support stand according to the first embodiment of the present disclosure.
FIG. 11 is a schematic structural diagram illustrating a first rotating component and a first drive mechanism according to the first embodiment of the present disclosure.
FIG. 12 is a schematic structural diagram illustrating a second rotating component and a second drive mechanism according to the first embodiment of the present disclosure.
FIG. 13 is a schematic structural diagram illustrating a moving head display device according to a second embodiment of the present disclosure.
FIG. 14 is a schematic structural diagram illustrating a moving head display device according to a third embodiment of the present disclosure.
FIG. 15 is a schematic structural diagram illustrating a moving head display device according to a fourth embodiment of the present disclosure.
FIG. 16 is a schematic structural diagram illustrating a moving head display device according to a fifth embodiment of the present disclosure.
FIG. 17 is a schematic structural diagram illustrating a moving head display device according to a sixth embodiment of the present disclosure.
FIG. 18 is a schematic structural diagram illustrating a moving head display device according to a seventh embodiment of the present disclosure.

### Description of the reference numerals:

100, display screen module; 110, support frame; 111, second connector; 112, first splicing and locking structure; 113, second splicing and locking structure; 114, electrical control box; 115, positioning pin; 116, screw; 120, display unit; 121, display unit bottom case; 122, lamp board; 123, display unit cover; 124, second magnetic member; 200, spot lamp; 210, spot lamp bottom case; 211, connecting tab; 212, fastener; 220, spot lamp cover; 221, light transmission hole; 230, circuit board; 240, illumination lamp bead; 250, condensing lens; 300, support stand; 310, base; 311, support foot; 312, mounting hole; 320, support arm; 321, support inner frame; 322, support housing; 3221, fixed arm; 3222, receiving groove; 330, holding plate; 331, first connector; 410, first rotating shaft; 420, first bearing seat; 430, first bearing; 510, first motor; 520, first pulley; 530, first synchronous belt; 540, second pulley; 610, second rotating shaft; 620, second bearing seat; 630, second bearing; 640, bottom support plate; 710, second motor; 720, third pulley; 730, second synchronous belt; 740, fourth pulley; and 800, first electric wire.

### DETAILED DESCRIPTION OF THE PREFERRED EMBODIMENT

In order to make the objects, technical solutions and advantages of the present disclosure more clear, the present disclosure will be further described in detail below with reference to the drawings and specific embodiments. It should be understood that the specific embodiments described herein are merely illustrative of the disclosure and are not intended to limit the scope of the disclosure.

It should be noted that when an element is referred to as being "fixed" to another element, it may be directly fixed to the other element or intervening elements may be present. When an element is referred to as being "connected" to another element, it may be directly connected to the other element or intervening elements may be present. In addition, unless otherwise specified, the terms "first", "second", etc. may be used herein to distinguish various components, elements, steps, etc., and are not intended to represent the logical relationship or order relationship between various components, elements, and steps. Finally, the terms "upper", "lower", "left", "right", "vertical", "horizontal", "top", "bottom", "inside" or "outside", which indicate orientations or positional relationships, may be used herein based on the orientations or positional relationships shown in the drawings, and are merely for the convenience of the description of the present disclosure and the simplified description, and do not indicate or imply that the device or component referred to has a specific orientation, which has to be constructed and operated in a specific orientation, therefore not to be construed as limiting the disclosure.

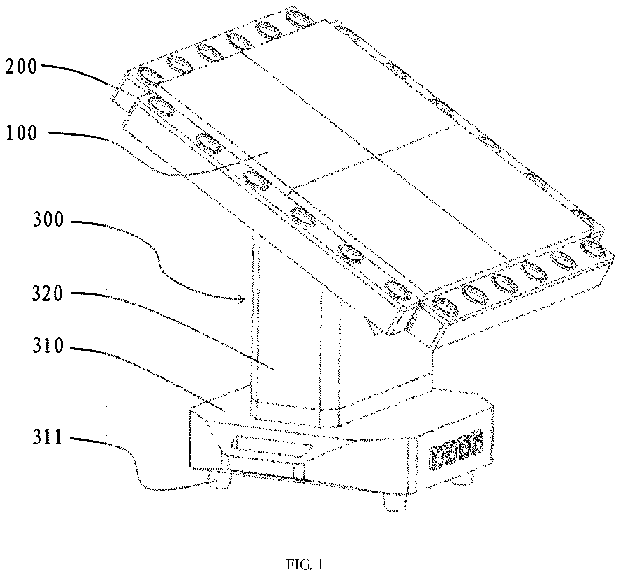

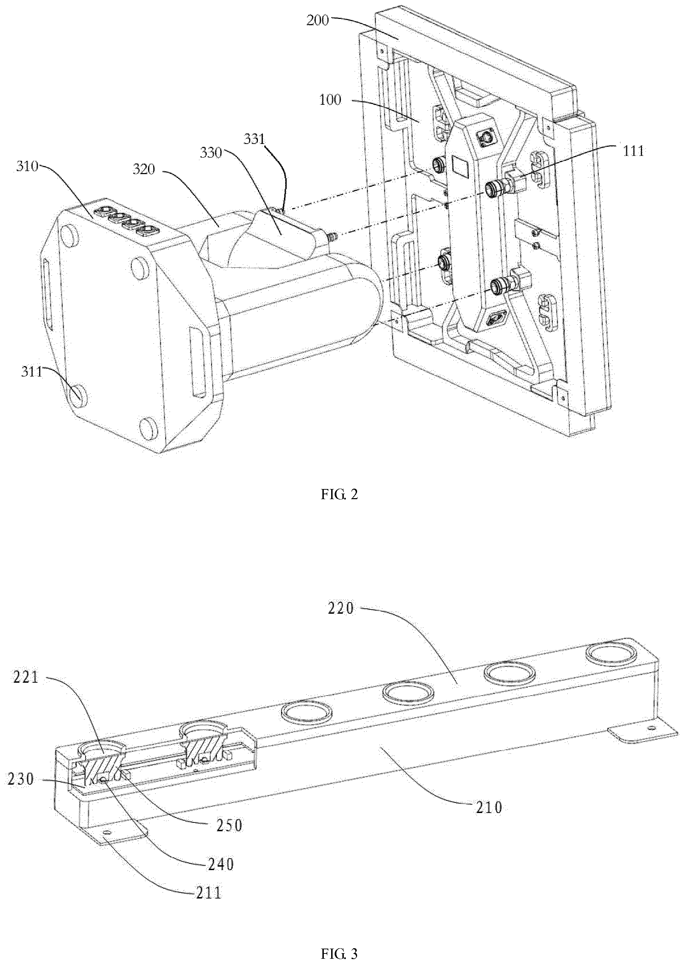

As shown in FIG. 1 and FIG. 2, a moving head display device includes a support stand 300 and a display screen module 100 disposed on the support stand 300. A first connector 331 is disposed on a side of the support stand 300 connected to the display screen module 100, and a second connector 111 is disposed on a back surface of the display screen module 100. The second connector 111 is detachably connected to and engaged with the first connector 331. If the first connector 331 is a connecting pin, the second connector 111 is provided with a connecting hole cooperated with the connecting pin; or if the first connector 331 is provided with a connecting hole, the second connector 111 is a connecting pin cooperated with the connecting hole. There may be four first connectors 331 and four second connectors 111, so that the display screen module 100 can be fixed securely and reliably. It should be noted that, the connection between the first connector 331 and the second connector 111 may be designed in other snap fit types according to actual needs.

For the moving head display device according to embodiments of the present disclosure, the display screen module 100 is mounted on the support stand in a snap fit manner, so that it is convenience to install the display screen module 100. The display screen module 100 can be supported on the ground or mounted on other holders by the support stand 300, to facilitate installation and positioning of the display screen module 100. Moreover, the display screen module 100 is easy to be detached from the support stand 300, and it is convenient to splice a plurality of display screen modules 100 into a large-area display screen to realize a function of large-area display. When the function of large screen display is not required, the spliced display screen modules 100 can be split to be installed into their respective support stands 300 to serve as stage lamps. The moving head display device according to the present disclosure is extremely flexible in use, and reasonably structured so that it is simple in structure and easy to manufacture .

In this embodiment, the moving head display device further includes a spot lamp 200 disposed on the display screen module 100, and the spot lamp 200 is detachably connected to the display screen module 100. The spot lamp 200 is a high power LED spot lamp 200. In this embodiment, the spot lamp 200 and the display screen module 100 are combined to form a display and lighting portion, so that the moving head display device can be used both for displaying a played video, dynamic images, or the like, and for lighting, decoration or other functions of a lamp. The spot lamp 200 is detachably connected to the display screen module, so that if it is not necessary to use both the display and lighting capacities of the moving head display device, the spot lamp 200 can be removed from the moving head display device, and the spot lamp 200 and the display screen module 100 can be used separately, further increasing the operational flexibility of the moving head display device, and integrating multiple functions into one machine to avoid the phenomenon that the conventional display unit 120 and the lighting unit cannot be used separately and avoid wasting resources. Moreover, the removal of the spot lamp 200 also facilitates to splice the display screen modules 100 into a large-area display screen.

In addition, as shown in FIG. 1, the spot lamp 200 is disposed on an outer perimeter of the display screen module 100, and a light emitting surface of the spot lamp 200 and a light emitting surface of the display screen module 100 are located a the same side, so that the audience can watch both images displayed on the display screen module 100 and light beam from the spot lamp 200, thereby avoiding the defect that the traditional display portion and the lighting portion are located on opposite sides, so that the display and lighting functions cannot be obtained at the same time.

There is a plurality of spot lamps 200, and the plurality of spot lamps 200 are circumferentially disposed around the outer perimeter of the display screen module 100. For example, the number of the spot lamps 200 is four, and the four spot lamps 200 are respectively disposed on four sides of the display screen module 100. Thereby, each edge of the display screen module 100 is provided with one spot lamp 200 to increase the lighting effect.

Specifically, as shown in FIG. 3, the spot lamp 200 includes a spot lamp bottom case 210, a spot lamp cover plate 220 connected to the spot lamp bottom case 210, an aluminum circuit board 230 disposed within the spot lamp bottom case 210, illumination lamp beads 240 (LED lamp beads) linearly arranged and equally distributed on the circuit board 230, and condensing lenses 250 corresponding to the illumination lamp beads 240 respectively and disposed directly above the illumination lamp beads 240 respectively. The spot lamp cover plate 220 is provided with light-transmitting holes 221 corresponding to the illumination lamp beads 240 respectively. In this embodiment, the spot lamp bottom case 210 is provided with a connecting tab 211. The connecting tab 211 is attached to the back surface of the display screen module 100 and is locked and fixed by a fastener 212. The mounting and fixing mode makes the spot lamp 200 easy to assemble and disassemble.

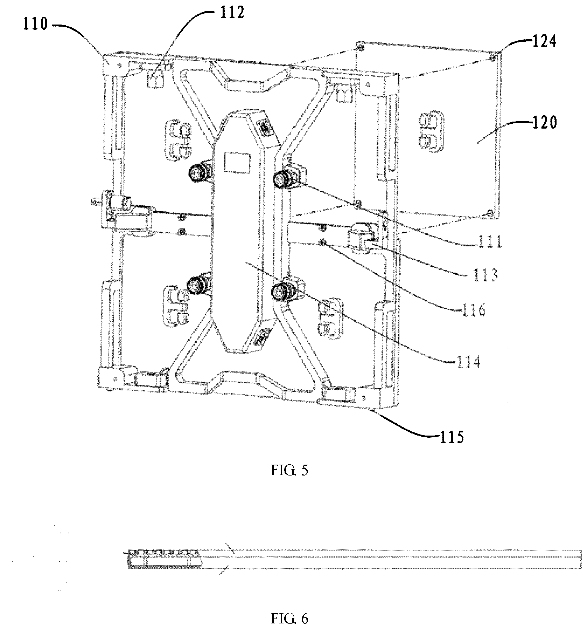

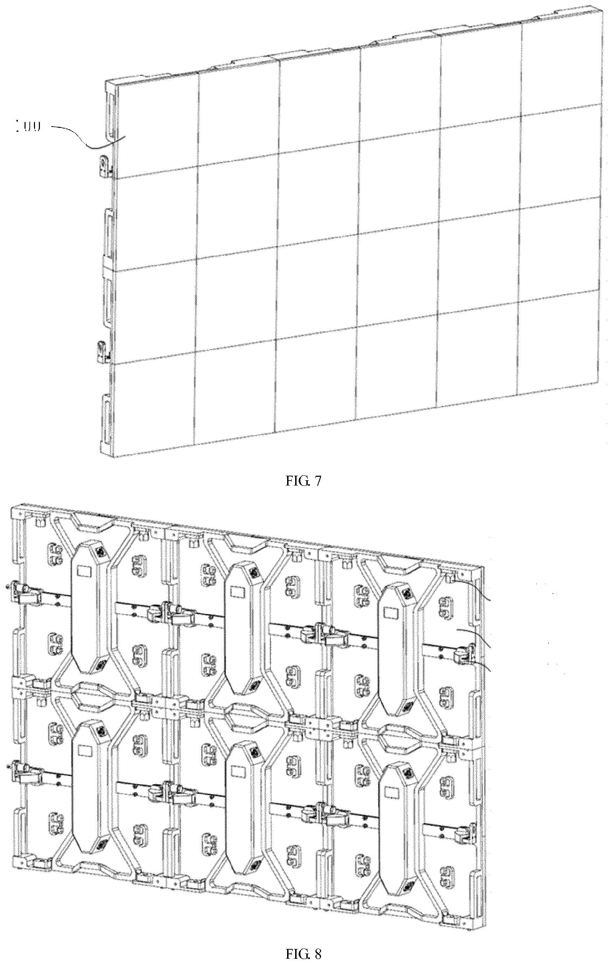

As shown in FIG. 5, the display screen module 100 in this embodiment includes a metal support frame 110 and one or more display units 120 disposed on the support frame 110. The support frame 110 is provided with a front surface facing the display unit 120 and a back surface facing away from the display unit 120. The second connector 111 is disposed on the back surface of the support frame 110. A splicing part is disposed on the support frame 110 and adapted to be connected to an adjacent display screen module 100 during splicing. The splicing part may be an edge of the back surface of the support frame 110. The splicing part is provided with a splicing and locking structure. The splicing and locking structure can both splice a plurality of display screen modules 100 together, as shown in FIG. 7 and FIG. 8, and separate the spliced plurality of display screen modules 100 from each other.

Specifically, the splicing and locking structure includes a first splicing and locking structure 112 for splicing up and down, and a second splicing and locking structure 113 for splicing left and right. The first splicing and locking structure 112 is disposed on up and down sides of the support frame 110, and the second splicing and locking structure 113 is disposed on left and right sides of the support frame 110. The arrangement of the first splicing and locking structure 112 and the second splicing and locking structure 113 can connect a single display screen module 100 to other display screen modules 100 in an adjacent upper side, lower side, left side, and right side reliably. It should be noted that the splicing and locking structure described in this embodiment may be a snap fit type connection structure or other detachable connection structure. Moreover, the display screen module 100 may be not necessarily a square structure, and may also be a triangle or other shape structure. When it is a triangular structure, the splicing and locking structure includes splicing units respectively located on three sides.

A lower side of the support frame 110 is provided with a positioning pin 115, and an upper side of the support frame 110 is provided with a positioning hole cooperated with a positioning pin 115 on an adjacent display screen module (not shown). The arrangement of the positioning pin 115 facilitates the positioning of the display screen module 100 when display screen modules are spliced together. Moreover, the positioning pin 115 is disposed on the lower side of the support frame 110, so that the display screen module 100 can stand on the ground or other mounting surface to display, to avoid direct contact between the display unit 120 and the mounting surface, and avoid damage caused by bumping, scratching or the like.

Specifically, as shown in FIG. 6, the display unit 120 includes a display unit bottom case 121, a lamp board 122, and a display unit cover 123. The lamp board 122 is arranged inside the display unit bottom case 121, and provided with display beads (LED lamp beads) welded thereon. The display unit cover 123 is connected to the display unit bottom case 121 to cover the lamp board 122.

The spacing between the display beads in this embodiment is preferably less than or equal to 2 mm to increase the pixel density of the display screen module 100 and provide a clear and exquisite display image. It should be noted that the spacing between the display beads may be set to any value greater than 2 mm according to actual needs.

Further, as shown in FIG. 5, the display unit 120 is connected to the support frame 110 by magnetic members. Specifically, a front surface of the support frame 110 is provided with a first magnetic member (not shown), and the display unit 120 is provided with a second magnetic member 124 magnetically connected to the first magnetic member. The arrangement of the first magnetic member and the second magnetic member 124 can facilitate the assembly of the display unit 120 and the support frame 110. In addition, the display unit 120 can be locked and fixed to the support frame 110 by other fasteners such as screws 116 to prevent the display unit 120 from detaching from the support frame 110.

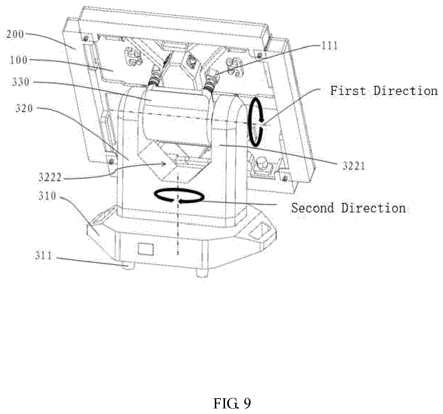

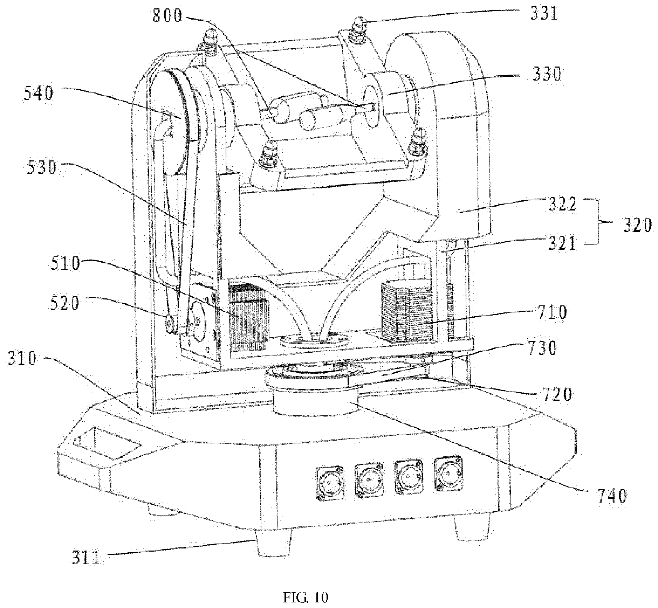

The specific configuration of the support stand 300 of the present disclosure will be described below. As shown in FIG. 9 and FIG. 10, the support stand 300 includes a base 310, a support arm 320 disposed on the base 310, and a holding plate 330 disposed on the support arm 320. The bottom of the base 310 is provided with four support legs 311 supported on a plane. The first connector 331 is disposed on the holding plate 330. The holding plate 330 is rotatably connected to the support arm 320 through a first rotating component such that the holding plate 330 is rotatable relative to the support arm 320 in a first direction. The support arm 320 is rotatably connected to the base 310 by a second rotating component such that the support arm 320 is rotatable relative to the base 310 in a second direction. When the holding plate 330 is driven by a driving force to rotate, the display screen module 100 and the spot lamp 200 can also be driven to rotate in the first direction, for example, a vertical direction, so that the display and lighting portion can swing in the vertical plane, thereby adjusting the angle of the display and lighting portion in the vertical direction. When the support arm 320 is driven by the driving force to rotate, the holding plate 330 and the display and lighting portion can also be driven to rotate in the second direction, for example, in a horizontal direction, thereby adjusting the angle of the display and lighting portion in the second direction. The combination of rotation in the first direction and the second direction realizes three-dimensional rotation of the display and lighting portion.

The support arm 320 includes a support inner frame 321 fixed to the base 310 and a support housing 322 disposed on an outer side of the support inner frame 321. The support housing 322 is provided with a receiving groove 3222 and two fixed arms 3221 located at two sides of the receiving groove 3222. Each of the two fixed arms 3221 has a U-shaped arm shape. The holding plate 330 is disposed in the receiving groove 3222, and the holding plate 330 is connected to the two fixed arms 3221 by the two first rotating components respectively. The receiving groove 3222 is provided for mounting the holding plate 300, and the fixed arms 3221 on both sides provide stable fixation for the holding plate 330, so the holding plate 330 can rotate smoothly and reliably.

The moving head display device in this embodiment further includes a first drive mechanism and a second drive mechanism. The first drive mechanism is configured to drive the holding plate 330 to rotate in a first direction relative to the support arm 320. The second drive mechanism is configured to drive the support arm 320 to rotate in a second direction relative to the base 310. The first drive mechanism and the second drive mechanism are both disposed inside the support arm 320. The arrangement of the first drive mechanism and the second drive mechanism can realize automatic three-dimensional rotation of the display and lighting portion.

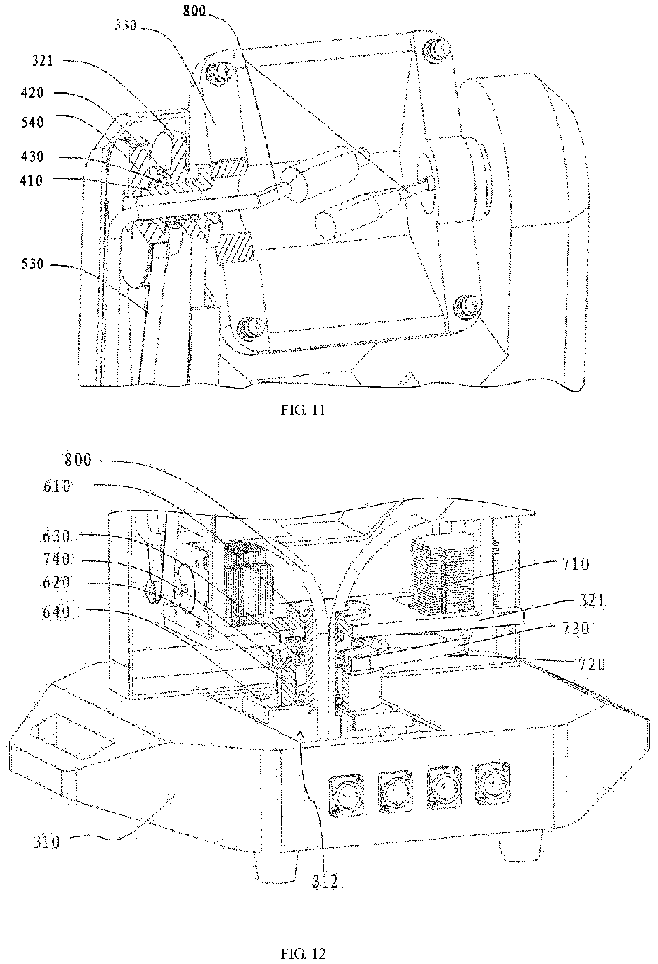

Specifically, as shown in FIG. 11, the first rotating component includes a first rotating shaft 410 fixedly connected to the holding plate 330, and the first rotating shaft 410 is rotatably supported on the supporting inner frame 321. The first rotating component further includes a first bearing seat 420 sleeved on the first rotating shaft 410, and the first bearing seat 420 is fixed on the supporting inner frame 321 . A first bearing 430 is further disposed between the first bearing seat 420 and the first rotating shaft 410, so that the first rotating shaft 410 and the first bearing seat 420 can relatively rotate to each other. Referring to FIG. 10, the first drive mechanism includes a first motor 510 disposed on the support inner frame 321, a first pulley 520 connected to an output end of the first motor 510, a second pulley 540 connected to the rotating shaft 410 and a first synchronous belt 530 disposed between the first pulley 520 and the second pulley 540. When the first motor 510 rotates, the second pulley 540 is driven by the first synchronous belt 530 to rotate, and the second pulley 540 further drives the first rotating shaft 410 and the holding plate 330 to rotate together, thereby finally realizing the swing of the display screen module 100 and the spot lamp 200 in the vertical direction. It should be noted that the position of the first rotating shaft 410 and the position of the first bearing seat 420 may be interchanged according to actual needs, that is, the first rotating shaft 410 may be fixed on the supporting inner frame 32, and the first bearing seat 420 may be fixed on the holding plate 330. At this case, the second pulley 540 of the first drive mechanism is fixed on the first bearing seat 420 for driving the first bearing seat 420 to rotate relative to the first rotating shaft 410.

As shown in FIG. 12, the second rotating component includes a second rotating shaft 610 fixedly connected to the support inner frame 321, the second rotating shaft 610 is rotatably supported on the base 310. The second rotating component further includes a second bearing seat 620 sleeved on the second rotating shaft 610, and the second bearing seat 620 is fixed on the base 310. A second bearing 630 is further disposed between the second bearing seat 620 and the second rotating shaft 610, so that the second rotating shaft 610 and the second bearing seat 620 can relatively rotate to each other. The second drive mechanism includes a second motor 710 fixed on the support inner frame 321, a third pulley 720 disposed on an output end of the second motor 710, a fourth pulley 740 fixed on the second bearing seat 620, and a second synchronous belt 730 disposed between the third pulley 720 and the fourth pulley 740. When the second motor 710 rotates, since the fourth pulley 740 is fixed relative to the base 310, the third pulley 720 will rotate around the fourth pulley 740, so as to drive the entire support arm 320 to rotate in the horizontal direction. It should be noted that, the position of the second rotating shaft 610 and the position of the second bearing seat 620 may be interchanged according to actual needs, that is, the second rotating shaft 610 is fixed on the base 310, and the second bearing seat 620 is fixed on the support inner frame 321. In this case, the second pulley 740 of the second drive mechanism is fixed on the second rotating shaft 610 for driving the second bearing seat 620 to rotate relative to the second rotating shaft 610.

The base 310 in this embodiment is provided with a mounting hole 312, and the second rotating component further includes a bottom support plate 640 fixed on an inner side of the base 310 and located below the mounting hole 312. The second bearing seat 620 is fixed on the bottom support plate 640.

The base 310 in this embodiment is provided with a built-in first power source (not shown) and a built-in control circuit board (not shown). The first power source is configured to supply power to the display screen module 100, the spot lamp 200, the first drive mechanism, and the second drive mechanism. The control circuit board is configured to transmit control signals to the display screen module 100, the spot lamp 200, the first drive mechanism, and the second drive mechanism or the like to to control their operation. The electrical connections between the power source and the powered unit and between the control circuit board and the controlled unit can be achieved by a first electric wire 800. Specifically, as shown in FIG. 11 and FIG. 12, a first through hole is disposed in the first rotating shaft 410, and a second through hole is disposed in the second rotating shaft 610. One end of the first electric wire 800 is disposed within the base 310 and configured to be electrically connected to the first power source and/or the control circuit board, and the other end is led into the receiving groove 3222 through the mounting hole 312, the second through hole, the inner side of the support arm 320, and the first through hole successively, and configured to be electrically connected to the display screen module 100, the spot lamp 200, and the like. Further, the first electric wire 800 in this embodiment is led out from the first rotating shaft 410, the inner side of the support arm 320, and the second rotating shaft 610, so that the first electric wire 800 is received in a concealed form. In addition, the first through hole and the second through hole may leave enough space to ensure that the first wire 800 does not fall off the two holes due to the rotation of the structures.

In addition, as shown in FIG. 5, an electrical control box 114 is further disposed on the back surface of the support frame 110 in this embodiment, and a second power source (not shown) and an image control card (not shown) are disposed within the electrical control box 114. The second power source is configured to supply power to the display unit 120, the image control card, etc., so that when the display screen module 100 is removed from the moving head display device, the display screen module 100 can also operate independently. The image control card is configured to be electrically connected to the display unit 120 and control the display screen module 100 to play a video.

The moving head display device in this embodiment further include a second electric wire, the front surface of the support frame 110 is provided with a retaining structure (not shown) for receiving the second electric wire. The second electric wire is disposed within the retaining structure to implement a series connection of a plurality of spot lamps 200.

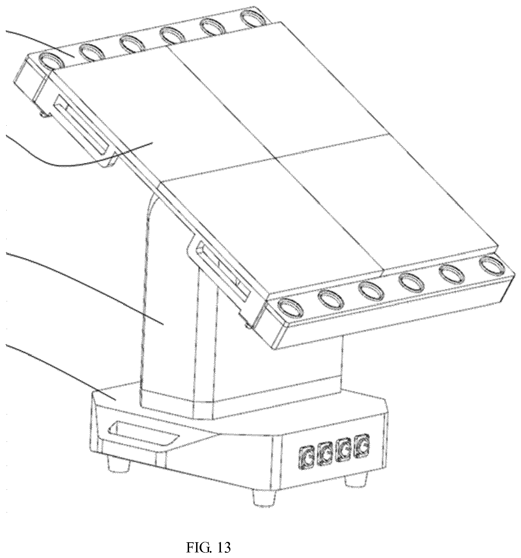

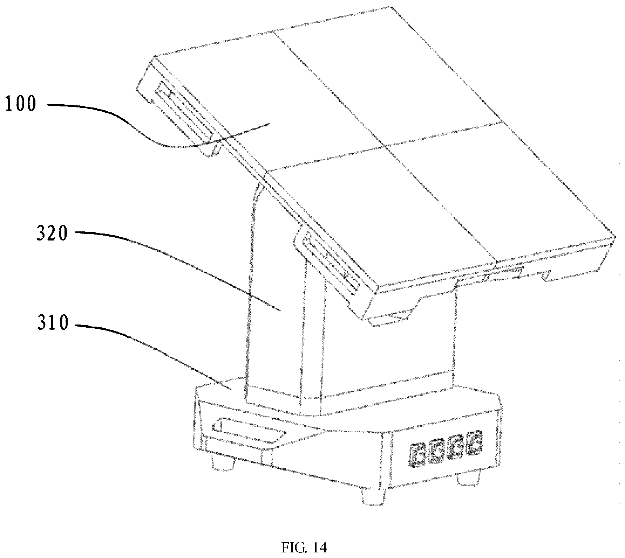

Different from the above embodiment, in the embodiment shown in FIG. 13, there are two spot lamps 200, while in the embodiment shown in FIG. 14, there is no spot lamp 200 disposed on the display screen module 100. It should be noted that any number of spot lamps 200 can be disposed on the display screen module 100 according to actual needs by those skilled in the art.

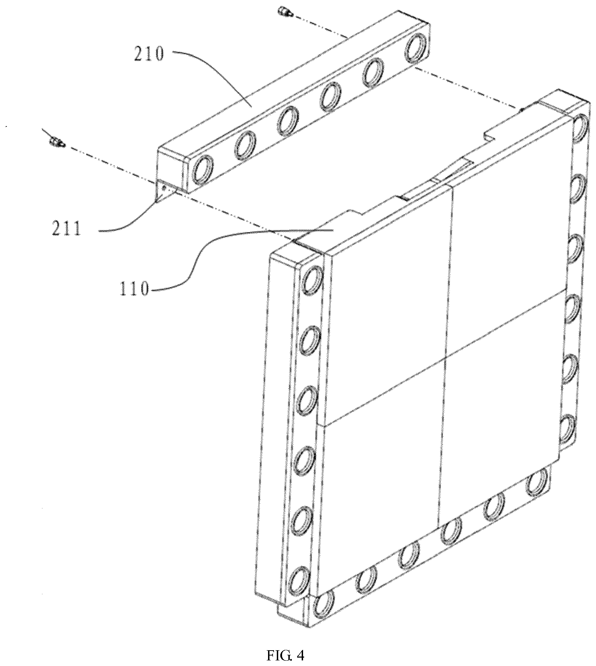

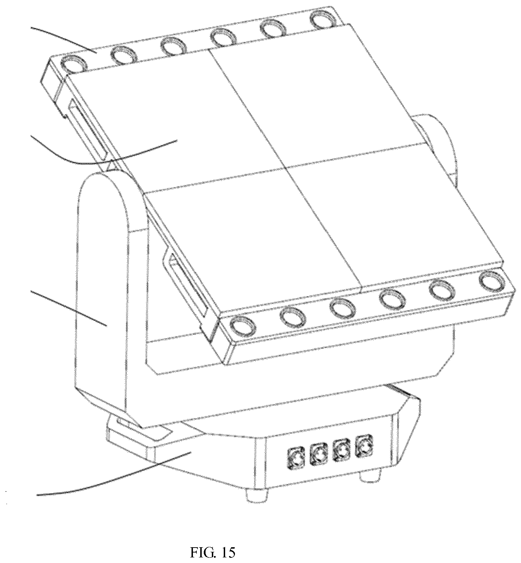

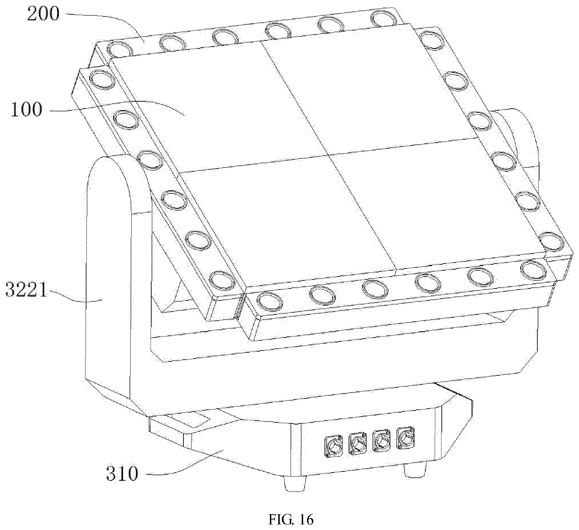

In addition, in the embodiments shown in FIG. 1 to FIG. 14, both of the two fixed arms 3221 are disposed on the back surface of the display screen module 100, so that some mounting support structures are hidden on the back surface of the display screen module 100, to reduce the size, and improve the appearance. Moreover, the fixed arm 3221 is fixed to the back surface of the display screen module 100 instead of the two sides of the display screen module 100, so that it is convenient for the installation of the spot lamp 200. It should be noted that, in other embodiments, for example, as shown in FIG. 15, the fixed arms 3221 may be also disposed on the left and right sides of the display screen module 100. In this case, the spot lamps 200 may be only mounted on upper and lower sides of the display screen module 100. The fixed arms 3221 may be still rotatably connected to the holding plate 330. Alternatively, in an embodiment shown in FIG. 16, the fixed arms 3221 may be also disposed on left and right sides of the display screen module 100, but the spot lamps 200 may be disposed on each of upper, lower, left, and right sides of the display screen module 100, and the spot lamps 200 disposed on the left and right sides are located between the two fixed arms 3221.

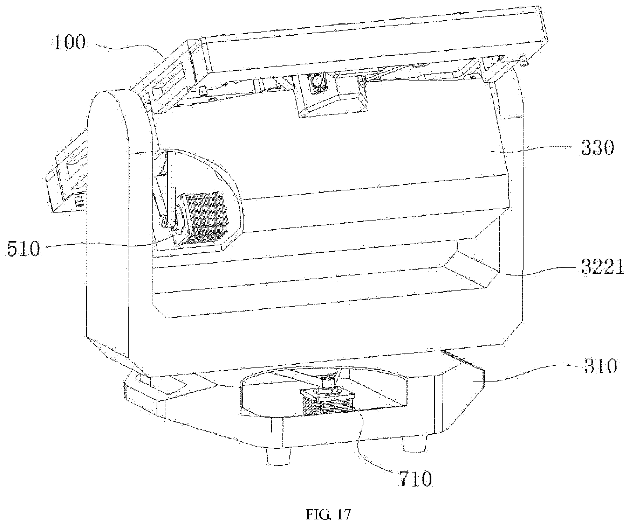

Different from the above embodiments, in an embodiment shown in FIG. 17, the first motor 510 and the second motor 710 are not fixed to the inner side of the support arm 320, but the first motor 510 is fixed to the inner side of the holding plate 330, and the second motor 710 is fixed to the inner side of the base 310, to reduce the thickness and weight of the support arm 320. When the first motor 510 is fixed to the inner side of the holding plate 330, the second pulley 540 in the first drive mechanism is fixedly connected to the first bearing seat 420 or the first rotating shaft 410 fixed on the supporting arm 320, so that the first motor 510 rotates together with the holding plate 330 in the vertical direction. When the second motor 710 is fixed to the inner side of the base 310, the fourth pulley 740 in the second drive mechanism is fixedly connected to the second rotating shaft 610 or the second bearing seat 620 fixed on the supporting arm 320, so that the second pulley 740 can be driven by the second motor 710 to rotate, and in turn the entire support arm 320 can be driven to rotate in the horizontal direction.

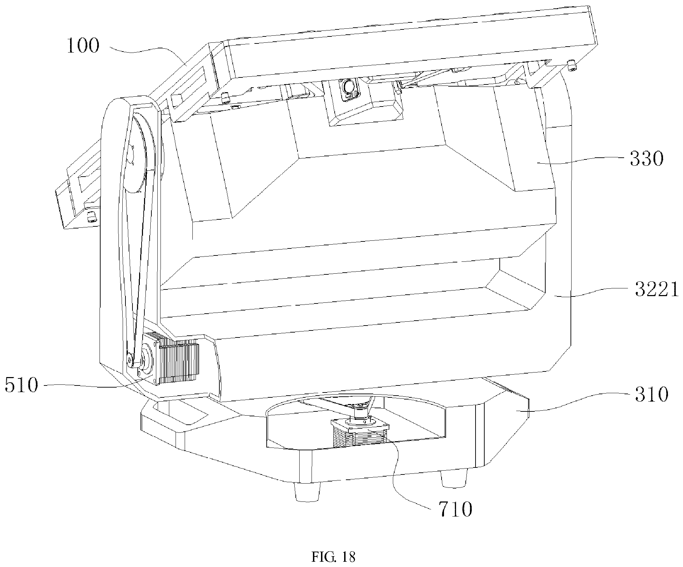

Different from the above embodiments, in an embodiment shown in FIG. 18, one or two first motors 510 are fixed to the inner side of the support arm 320, and the second motor 710 is fixed to the inner side of the base 310. In this case, the second pulley 540 in the first drive mechanism drives the first rotating shaft 410 or the first bearing seat 420 fixed on the holding plate 330 to rotate, thereby realizing the rotation of the holding plate 330. The fourth pulley 740 in the second drive mechanism drives the second rotating shaft 610 or the second bearing seat 620 fixed on the supporting arm 320 to rotate, thereby realizing the rotation of the supporting arm 320. It should be noted that there may be one or two first drive mechanisms (including the first motor 510) in all embodiments of the present disclosure. When the number of the first drive mechanisms is two, each of the first drive mechanisms is located in one of the fixed arms 3221 respectively for driving the holding plate 330 to rotate on both sides of the holding plate 330.

In addition, it should be noted that the installation positions of the first drive mechanism and the second drive mechanism can be set according to actual needs, and the several embodiments shown herein are only for explaining the present disclosure and cannot be the limits of the scope of the present disclosure.

From the above, this invention can be used as an LED display screen to play a video and also realize the effect of stage lighting, which integrates multiple functions into one machine and presents a special and beautiful visual effect. Specifically, after power-on, the following effects can be achieved by control software: (1) the LED display screen module 100 can play video images; (2) the high-power LED spot lamp 200 emits light and changes colors; (3) LED display screen module 100 and the high-power LED spot lamp 200 are controlled to rotate in a vertical direction with respect to the support arm 320; (4) the support arm 320 is controlled to rotate in a horizontal direction with respect to the base 310; and (5) the combination of several effects in the above (1) to (4) can be simultaneously achieved

There is any combination of the technical features of the above-described embodiments. For the sake of brevity of description, all possible combinations of the technical features in the above embodiments are not described. However, as long as there is no contradiction between the combinations of these technical features, it should be considered as the scope of this specification.

The above-described embodiments are merely illustrative of several embodiments of the present disclosure, and the description thereof is more specific and detailed, but is not to be construed as limiting the scope of the disclosure. It should be noted that a number of variations and modifications may be made by those skilled in the art without departing from the spirit and scope of the disclosure.

## Claims

1. A moving head display device, comprising: a support stand and a display screen module disposed on the support stand, wherein a side of the support stand facing the display screen module is provided with a first connector, a back surface of the display screen module is provided with a second connector, and the second connector is detachably connected to and engaged with the first connector.

2. The moving head display device according to claim 1, further comprising a spot lamp disposed on the display screen module, the spot lamp being detachably connected to the display screen module.

3. The moving head display device according to claim 2, wherein the spot lamp is disposed on an outer perimeter of the display screen module, and a light emitting surface of the spot lamp and a light emitting surface of the display screen module are located on a same side.

4. The moving head display device according to claim 1, wherein the display screen module comprises a support frame and a display unit disposed on the support frame, the support frame is provided with a splicing part adapted to be connected to an adjacent display screen module during splicing, and the splicing part is provided with a splicing and locking structure.

5. The moving head display device according to claim 4, wherein a lower side of the support frame is provided with a positioning pin, and an upper side of the support frame is provided with a positioning hole cooperated with a positioning pin on an adjacent display screen.

6. The moving head display device according to claim 4, wherein a side of the support frame facing the display unit is provided with a first magnetic member, and the display unit is provided with a second magnetic member adapted to be magnetically connected to the first magnetic member.

7. The moving head display device according to claim 1 or 2, wherein the support frame comprises a base, a support arm disposed on the base, and a holding plate disposed on the support arm, the holding plate is rotatably connected to the support arm through a first rotating component such that the holding plate is rotatable relative to the support arm in a first direction, the support arm is rotatably connected to the base such that the support arm is rotatable relative to the base in a second direction, and the holding plate is provided with the first connector.

8. The moving head display device according to claim 7, further comprising a first drive mechanism connected to the first rotating component and configured to drive the support plate to rotate relative to the support arm, and a second drive mechanism connected to the second rotating component and configured to drive the support arm to rotate relative to the base.

9. The moving head display device according to claim 7, wherein the support arm is provided with a receiving groove and two fixed arms located on both sides of the receiving groove, and the holding plate is disposed in the receiving groove, and the holding plate is connected to the two fixed arms by two first rotating component respectively.

10. The moving head display device according to claim 7, further comprising a first electric wire, wherein the base is provided with a built-in first power source and a built-in control circuit board, the first rotating component is provided with a first through hole, the second rotating component is provided with a second through hole, one end of the first electric wire is disposed within the base and configured to be electrically connected to the first power source and/or the control circuit board, and another end of the first electric wire is electrically connected to the display screen module through the second through hole, an inner side of the support arm, and the first through hole successively.
